# FASCICULE DE BREVET EUROPEEN

(11) **EP 1 292 991 B1**
(45) Date de publication et mention de la délivrance du brevet: **11.05.2011**
(21) Numéro de dépôt: 01947563.1
(22) Date de dépôt: 21.06.2001
(51) Int. Cl.: H01L 21/336, H01L 29/78, H01L 29/06, H01L 29/49, H01L 29/45

(54) **Procédé de fabrication d'un transistor MOS vertical à grille enterrée**
Verfahren zur Herstellung eines vertikalen MOS-Transistors mit vergrabenem Gate
Method of making a vertical MOS transistor having a buried gate

(30) Priorité: 22.06.2000 FR 0008016
(43) Date de publication de la demande: 19.03.2003
(73) Titulaire: Commissariat à l'Énergie Atomique et aux Énergies Alternatives, 75015 Paris (FR)
(72) Inventeur: DELEONIBUS, Simon, F-38640 Claix (FR)
(74) Mandataire: Ilgart, Jean-Christophe
(86) Numéro de dépôt international: PCT/FR2001/001950
(87) Numéro de publication internationale: WO 2001/099197

(56) Documents cités:
- EP-A2- 0 908 938
- WO-A-97/48135
- DE-A- 19 746 901
- GB-A- 2 103 879
- US-A- 5 136 350
- US-A- 5 739 057

## Description

### DOMAINE TECHNIQUE

La présente invention concerne un procédé de fabrication d'un transistor MOS (Métal-Oxyde-Semiconducteur) vertical.

Elle trouve des applications en microélectronique pour la fabrication de divers dispositifs comme par exemple les inverseurs numériques qui utilisent des transistors MOS complémentaires l'un de l'autre.

### ETAT DE LA TECHNIQUE ANTERIEURE

On connaît déjà un grand nombre de transistors MOS latéraux (encore appelés « transistors MOS plans »).

On connaît en particulier un transistor MOS latéral à puits quantique (« quantum well latéral MOS transistor »), ayant une structure de type pseudo-SOI, par le document WO97/48135 auquel on se reportera.

Le document DE 19746901 décrit par ailleurs un procédé de fabrication d'un transistor de type MOS vertical. US 5739057 décrit aussi un tel procédé.

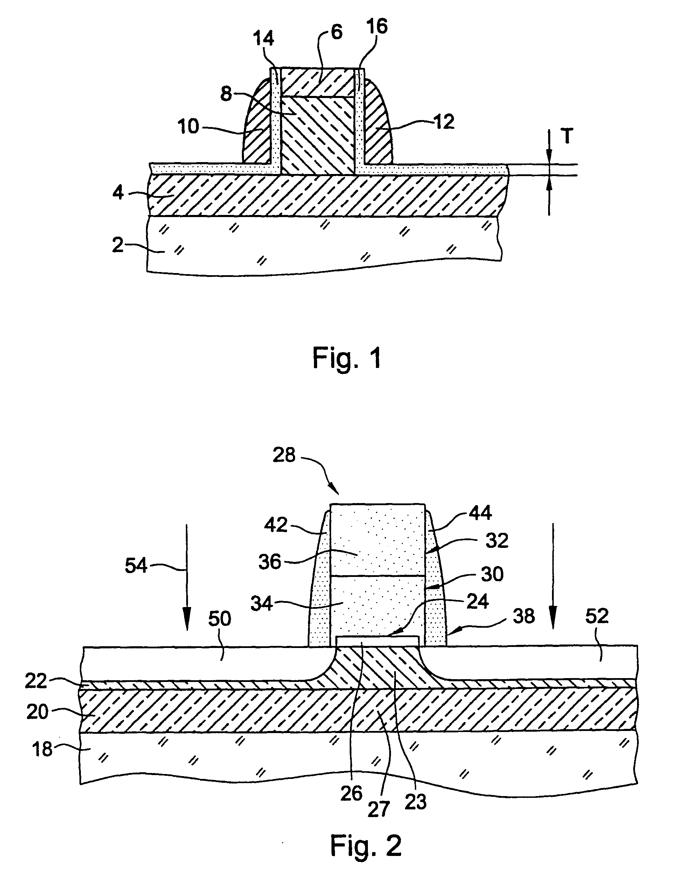

La figure 1 est une vue en coupe transversale schématique d'un transistor MOS vertical connu.

Ce transistor MOS vertical est formé sur un substrat semiconducteur 2 et comprend une source 4 en matériau semiconducteur, formée sur le substrat 2, un drain semiconducteur 6, disposé au-dessus de la source 4 et de type de dopage identique à celui de cette dernière, et un canal semiconducteur 8 compris entre la source et le drain et de type de dopage opposé à celui de la source.

Le transistor de la figure 1 comprend aussi une grille électriquement conductrice, composée de deux zones 10 et 12 qui encadrent l'ensemble formé par le drain 6 et le canal 8.

Ce transistor comprend en outre un isolant de grille qui est composé de deux couches minces électriquement isolantes 14 et 16 séparant respectivement les zones de grille 10 et 12 du drain 6 et du canal 8 et se prolongeant , sensiblement à angle droit, à la surface de la source 4, en isolant ainsi cette dernière des zones de grille 10 et 12.

Le transistor MOS vertical de la figure 1 présente un inconvénient.

En effet, la capacité parasite (« stray capacitance ») entre la grille et la source de ce transistor est trop grande. Cela résulte du fait que cette capacité est inversement proportionnelle à l'épaisseur T de l'isolant de grille. Or, entre la grille et le canal du transistor, on a besoin d'un isolant de faible épaisseur car on souhaite qu'un courant électrique élevé puisse circuler dans ce canal et l'on peut montrer que ce courant est une fonction décroissante de l'épaisseur T.

Il convient aussi de noter que la capacité entre la grille et le drain du transistor de la figure 1 est minimisée par la présence de l'isolant de grille (composé des deux couches 14 et 16).

Ce transistor MOS vertical connu présente un autre inconvénient : la distance entre la grille et le drain du transistor de la figure 1 ne peut être rendue inférieure à une distance minimale, fixée par la tolérance d'alignement des machines d'insolation que l'on utilise pour la fabrication des transistors verticaux de ce genre.

### EXPOSÉ DE L'INVENTION

La présente invention a pour objet un procédé de fabrication d'un transistor MOS vertical, qui permet de remédier aux inconvénients précédents. Ce procédé est défini en revendication 1. Les revendications dépendantes couvrent des réalisations spécifiques. Le transistor de type MOS vertical comprend :
- un substrat semiconducteur,
- une source en matériau semiconducteur, formée dans ou sur ce substrat,
- un canal formé au-dessus de la source et fait d'un matériau semiconducteur ayant un type de dopage opposé à celui de la source,
- un drain formé au-dessus du canal et fait d'un matériau semiconducteur ayant un type de dopage identique à celui de la source, et
- une grille formée de part et d'autre du canal et du drain et électriquement isolée de la source, du canal et du drain,
   ce transistor étant caractérisé en ce qu'il comprend en outre :
- un ensemble électriquement isolant formé par-dessus la drain, cet ensemble électriquement isolant comprenant, de part et d'autre du drain, des zones électriquement isolantes appelées « espaceurs », et
- des cavités qui s'étendent sous l'ensemble électriquement isolant, de part et d'autre du canal, la grille étant formée de part et d'autre de cet ensemble électriquement isolant, des portions de la grille se trouvait dans les cavités.

Des couches minces, électriquement isolantes, s'étendent au moins entre le canal et ces portions de la grille et d'autres couches épaisses, électriquement isolantes, s'étendent entre la grille et la source.

Du fait des portions de la grille qui se trouvent dans ces cavités, on peut considérer que ce transistor de type MOS vertical possède une grille enterrée.

Selon un mode de réalisation préféré du transistor, la grille est faite d'un matériau métallique.

Selon un mode de réalisation particulier de ce transistor, la source, le canal et le drain sont faits à partir de silicium.

Dans ce cas, selon un mode de réalisation particulier, les couches électriquement isolantes, qui s'étendent au moins entre le canal et les portions de la grille, sont faites d'un matériau choisi parmi la silice, le nitrure de silicium et l'oxyde d'hafnium, que l'on note plus simplement HiK (matériaux de constantes diélectriques élevées).

La présente invention concerne un procédé de fabrication d'un transistor de type MOS vertical, dans lequel :
- on forme une structure comprenant un substrat semiconducteur, une zone de source, une zone de canal au dessus de la zone de source, et un drain au-dessus de la zone de canal,
- on forme, par-dessus le drain, un ensemble électriquement isolant comprenant des zones électriquement isolantes de part et d'autre du drain,
- on forme, dans la structure, deux évidements ce part et d'autre de l'ensemble électriquement isolant, les flancs respectifs de ces évidements les plus proches de l'ensemble électriquement isolant étant situés sous ce dernier, de part et d'autre de la zone de canal, pour former ainsi des cavités,
- on forme des couches minces, électriquement isolantes au moins sur ces flancs des évidements et d'autres couches épaisses, électriquement isolantes au fond de ces évidements, et
- on forme la grille du transistor de part et d'autre de l'ensemble électriquement isolant et jusque dans les cavités.
   Pour former l'ensemble électriquement isolant,
   - on forme, sur la structure, une première couche qui est électriquement isolante et, sur cette première couche, une deuxième couche qui est également électriquement isolante,
   - on grave ces première et deuxième couches de façon à obtenir un élément isolant qui recouvre le drain,
   - on forme, par-dessus cet élément isolant une troisième couche qui est également électriquement isolante, et
   - on grave cette troisième couche de façon à former les zones électriquement isolantes et à achever la formation de l'ensemble électriquement isolant.

De préférence, la deuxième couche est apte à servir de couche d'arrêt de planarisation à une couche de métal que l'on forme ultérieurement et qui est destinée à la formation de la grille du transistor.

Alors, cette deuxième couche est par exemple en nitrure de silicium ou en carbure de silicium.

De préférence, dans ce cas, la première couche est en outre apte à servir de couche-tampon.

selon le procédé objet de l'invention,
on forme, à travers l'ensemble électriquement isolant, un trou qui s'étend jusqu'au drain, et
l'on forme, dans ce trou, une couche de contact de drain; et l'on
forme en même temps la grille et cette couche de contact de drain.

De préférence, on forme la zone de source par implantation, dans le substrat, d'ions aptes à conduire à un dopage de ce substrat ou par épitaxie, sur ce substrat, d'un semiconducteur ayant ce dopage .

De préférence également, on forme le drain par épitaxie ou par implantation d'ions.

### BRÈVE DESCRIPTION DES DESSINS

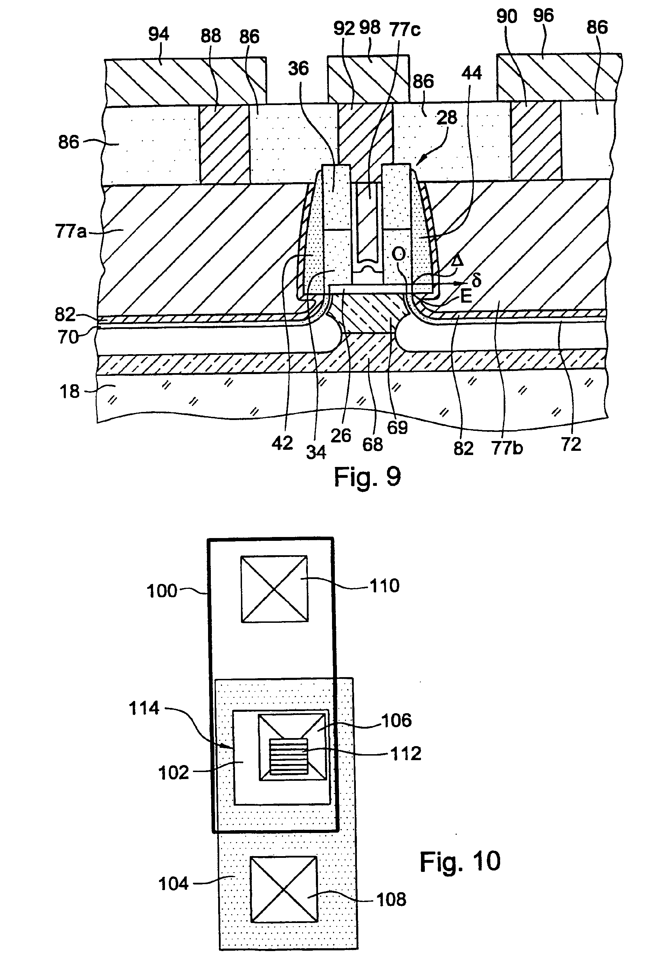

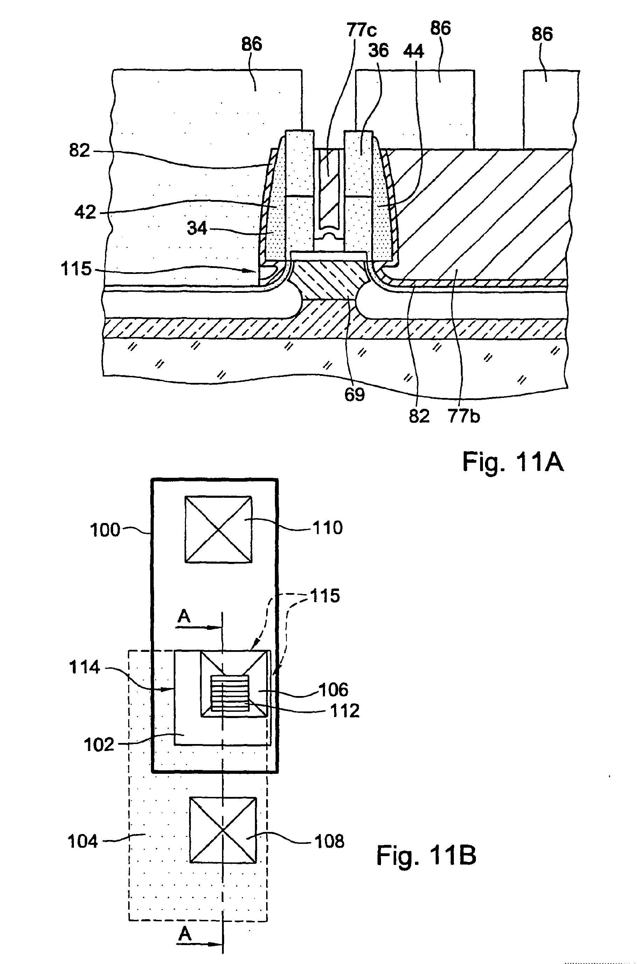

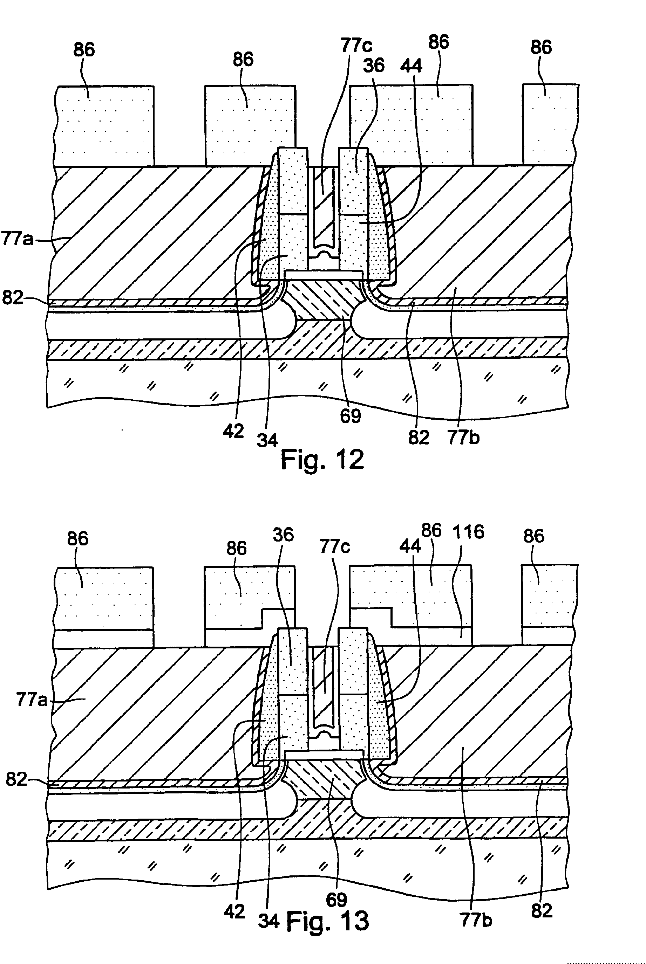

La présente invention sera mieux comprisse à la lecture de la description d'exemples de réalisation donnés ci-après, à titre purement indicatif et nullement limitatif, en faisant référence aux dessins annexés sur lesquels :
■ la figure 1 est une vue en coupe transversale schématique d'un transistor MOS vertical connu et a déjà été décrite,
■ les figures 2 à 9 illustrent schématiquement des étapes d'un mode de mise en oeuvre particulier du procédé objet de l'invention,
■ la figure 10 est une vue de dessus schématique et partielle d'un transistor obtenus par le procédé objet de l'invention,
■ la figure 11A est une vue en coupe transversale schématique d'un transistor obtenus par le procédé objet de l'invention dans lequel la garde entre la grille et le drain est nulle et la figure 11B obtenus par le procédé objet de est une vue de dessus schématique et partielle de ce transistor, et
■ les figures 12 et 13 sont des vues en coupe transversales schématiques de transistors MOS l'invention qui sont complémentaires l'un de l'autre.

### EXPOSÉ DÉTAILLÉ DE MODES DE RÉALISATION PARTICULIERS

Les figures 2 à 9 illustrent schématiquement des étapes d'un exemple du procédé objet de l'invention, permettant d'obtenir un transistor MOS vertical à grille métallique enterrée

Il convient de noter qu'un problème résolu par la présente invention est celui de la réduction, dans un transistor MOS vertical, des capacités parasites entre la grille et la source et entre la grille et le drain du transistor, tout en ayant un isolant électrique de faible épaisseur entre la grille et le canal du transistor.

Pour résoudre ce problème, l'invention propose de minimiser les zones de recouvrement entre, d'une part, la grille et le drain et, d'autre part, entre la source et la grille. Pour ce faire, le drain est reporté le plus loin possible tout en conservant un recouvrement de la grille. Par ailleurs, pour isoler la grille à la fois de la source et du drain, l'invention utilise un empilement de deux isolants, à savoir un isolant épais (formé par les couches isolantes épaisses 66 et 67 dans l'exemple considéré) et un isolant mince (formé par les couches isolantes minces 70 et 72 dans l'exemple considéré). L'isolant mince est situé au moins entre la grille et le canal parce que les performances du transistor dépendent de la valeur de la capacité entre grille et canal : plus l'isolant de grille est mince, plus le courant débité par le transistor est important. L'isolant épais est situé dessous et isole la grille de la source.

De plus, l'architecture du transistor obtenus par le procédé objet de l'invention permet de réduire les capacités parasites, d'une part en bord de grille, sur la zone de recouvrement entre source/grille et drain/grille, ce qui est très difficile à réaliser sur un transistor vertical, et d'autre part au niveau du contact pris sur le drain.

Pour mettre en oeuvre le procédé illustré par ces figures 2 à 9, on utilise un substrat semiconducteur monocristallin 18 qui, dans l'exemple représenté, est en silicium monocristallin de type p.

On dépose par épitaxie, sur ce substrat 18, une couche 20 de silicium de type n⁺ (et donc fortement dopé, par exemple au moyen de phosphore, d'arsenic ou d'antimoine), qui est destinée à la formation de la source du transistor.

Au lieu d'utiliser une épitaxie en vue de former cette source, on pourrait utiliser une implantation d'ions appropriés (par exemple des ions de phosphore, d'arsenic ou d'antimoine) dans le substrat 18.

On dépose ensuite par épitaxie, sur la couche 20, une couche 22 de silicium de type p (ou de SiGeₓCy de type p, qui est destinée à la formation du canal du transistor.

Le drain 26 du transistor est réalisé par dépôt par épitaxie, sur cette couche 22, d'une couche 24 de silicium de type n ou par une implantation de type n de la couche 22 pour obtenir la couche 24 du transistor au-dessus d'une zone 23 de la couche 22, correspondant au canal de ce transistor. En dessous de cette zone 23, la zone 27 de la couche 20 correspond à la source du transistor.

On forme ensuite, par-dessus le drain 26, un ensemble électriquement isolant 28 comme on l'explique ci-après.

On dépose d'abord une première couche 30 en silice au-dessus du drain 26 et de la couche 22 puis une deuxième couche 32 en nitrure de silicium sur cette couche 30.

On grave ensuite les couches 30 et 32 pour former, par-dessus le drain 26, deux zones électriquement isolantes, l'une 34 en silice et l'autre 36 en nitrure de silicium. L'empilement de ces zones 34 et 36 constitue ce que l'on appelle « la cheminée » du transistor.

On forme ensuite des zones électriquement isolantes appelées « espaceurs ». Pour ce faire, sur la structure résultant des étapes précédentes et donc sur la cheminée et la couche 22, on dépose une couche 38 de silice ou de nitrure de silicium et l'on grave cette couche 38 jusqu'à l'obtention de deux zones électriquement isolantes 42 et 44, constituant les espaceurs, qui se trouvent de part et d'autre de la cheminée (et donc de part et d'autre du drain 26) et au-dessus desquelles émerge l'extrémité supérieure de la zone 36 en nitrure de silicium.

On achève ainsi la formation de l'ensemble électriquement isolant 28.

On précise que la structure que l'on voit sur la figure 2 comprend aussi deux zones d'isolation de champ (non représentées) qui sont placées de part et d'autre de cet ensemble 28 et sont réalisées avant ce dernier, par exemple par la méthode appelée LOCOS. Ces zones d'isolation de champ sont destinées à isoler électriquement le transistor, que l'on veut former, d'autres transistors identiques (non représentés), également formés à partir du substrat 18 et des couches 20, 22 et 24.

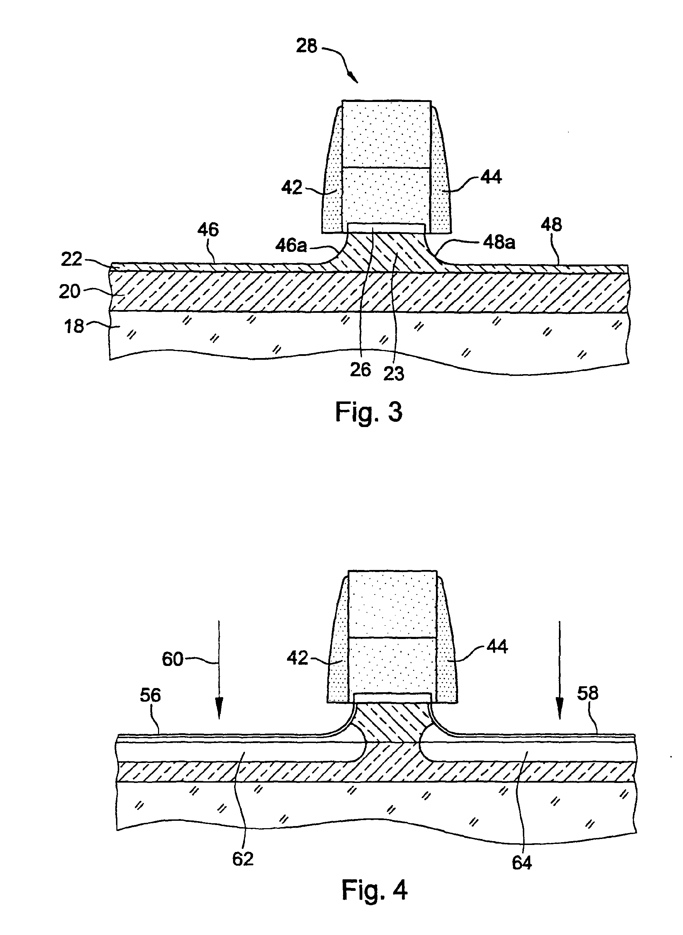

Dans la couche 22, on forme ensuite deux évidements 46 et 48 (figure 3) entre ces zones d'isolation de champ et la zone de canal 23. Ces évidements 46 et 48 s'étendent sous les espaceurs 42 et 44 et peuvent même s'étendre, si on le souhaite, sous le drain 26 du transistor.

Pour obtenir ces évidements 46 et 48, on peut procéder à une gravure de la couche 22 de façon isotrope et sélective par rapport à l'isolation de champ et aux espaceurs, pendant un temps approprié.

Cependant, pour une meilleure maîtrise géométrique de la structure finalement obtenue que l'on voit sur la figure 3, il est préférable, pour obtenir ces évidements 46 et 48, de réaliser une implantation à forte dose de type p⁺, par exemple au moyen de noyaux de bore, dans des zones 50 et 52 (voir la figure 2) de la couche 22, ces zones 50 et 52 correspondant aux évidements 46 et 48 que l'on veut obtenir. On voit aussi sur la figure 2 le faisceau 54 des ions B⁺ utilisés.

Un recuit d'implantation, suivi par une diffusion, permet d'ajuster la largeur du canal du transistor que l'on veut réaliser.

On effectue ensuite une gravure sélective du silicium p⁺ des zones 50 et 52 par rapport au silicium de type p de la couché 22 (où il n'y a pas eu d'implantation).

Un mélange utilisable pour ce faire est mentionné dans la demande internationale citée plus haut.

On réalise ensuite une nitruration des zones exposées, résultant de la gravure sélective mentionnée ci-dessus, au moyen de gaz amoniac par exemple, ce qui conduit à l'obtention de couches très minces 56 et 58 (figure 4) en nitrure de silicium sur les flancs 46a et 48a des évidements 46 et 48, flancs qui se trouvent sous l'ensemble 28, ainsi qu'au fond de ces évidements.

On procède ensuite à une implantation à forte dose, de type n⁺, par exemple au moyen d'un faisceau 60 d'ions As⁺ ou P⁺, dans la couche 22, au fond des évidements 46 et 48, à travers les couches 56 et 58. Les zones qui résultent de cette implantation ont les références 62 et 64 sur la figure 4.

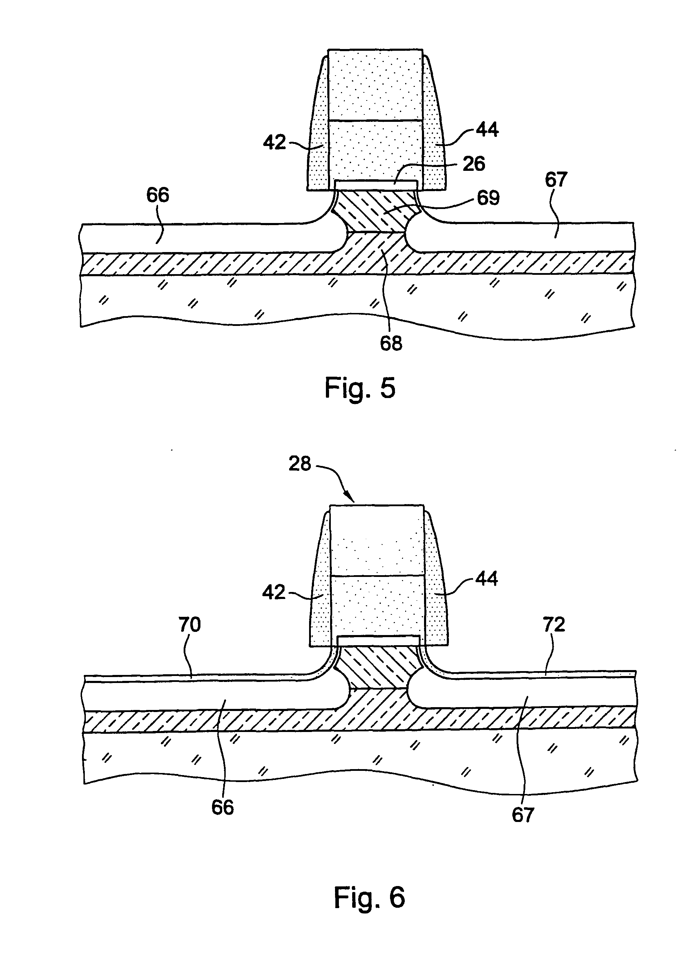

Après l'activation des dopants, on procède à une oxydation des zones implantées 62 et 64. Les zones ainsi oxydées ont les références 66 et 67 sur la figure 5. On a repéré, sur cette figure 5, la source 68 du transistor qui est située sous le canal 69 de ce transistor, ce canal étant lui-même situé sous le drain 26 du transistor.

On dépose ensuite un isolant de grille. Pour ce faire, on dépose des couches minces par exemple de silice 70 et 72 (figure 6) respectivement sur les zones 66 et 67 qui forment des couches isolantes épaisses, les zones 70 et 72 s'étendant jusqu'à la partie inférieure de l'ensemble électriquement isolant 28 comme on le voit sur la figure 6.

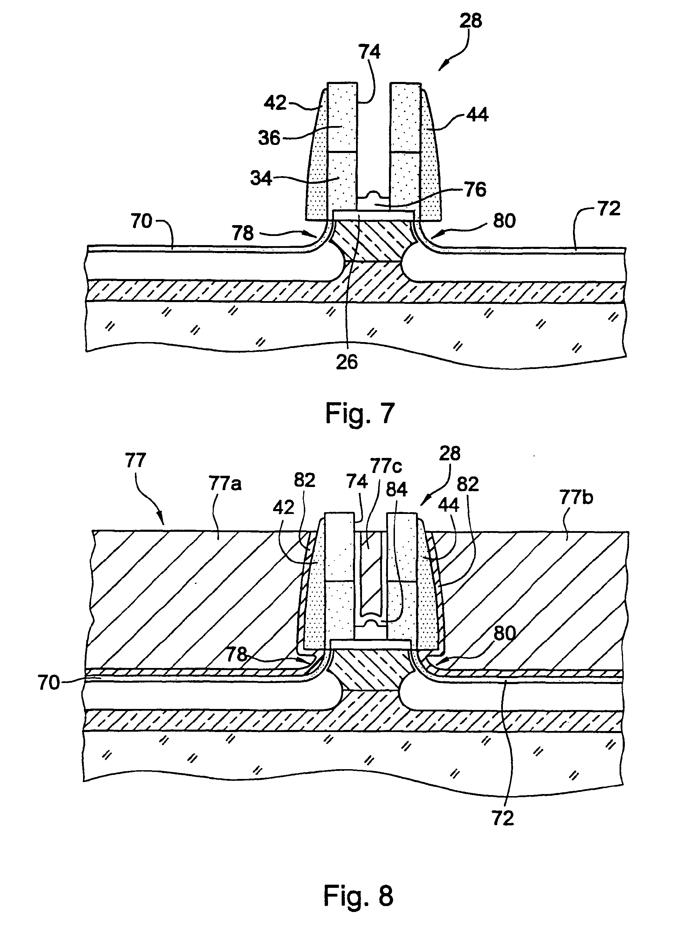

On forme ensuite un trou 74 (figure 7) atteignant le drain 26 par lithographie et gravure des zones 36 et 34 de l'ensemble électriquement isolant 28, puis on fait croître à l'intérieur du trou 74, par épitaxie sélective, une couche de contact de drain 76 en silicium ou en SiGeₓC_{y} ou encore en un métal qui est par exemple choisi parmi le cobalt, le tungstène et le titane. L'épaisseur de cette couche est réglable.

Il convient de noter que si l'on épitaxie le métal, un siliciure est susceptible de se former à l'interface entre ce métal et le drain 26.

On forme ensuite la grille du transistor, de part et d'autre de l'ensemble électriquement isolant 28 (figure 7), tout en complétant le contact de drain.

Il convient de noter que la grille n'est pas forcément métallique. Elle peut être réalisée en silicium polycristallin dopé n⁺ (respectivement p⁺) pour un transistor à canal n (respectivement p), par exemple déposé par un procédé LPCVD.

D'une façon générale elle peut être réalisée dans un matériau semiconducteur dopé, par exemple le silicium ou le germanium.

Selon un mode de réalisation avantageux, pour former la grille (tout en complétant le contact de drain), on dépose un métal, qui est par exemple choisi parmi le cobalt, le tungstène et le titane, sur la structure obtenue à la figure 7, par exemple par dépôt chimique en phase vapeur (« chemical vapor deposition »). Le métal ainsi déposé dépasse le niveau supérieur de la zone 36 en nitrure de silicium.

Ce métal est ensuite planarisé : on effectue un polissage de ce métal, la zone 36 servant de couche d'arrêt de polissage. On voit sur la figure 8 la couche métallique 77 planarisée ainsi obtenue, qui s'étend dans le trou 74 et de part et d'autre de l'ensemble 28.

La zone 34 sert non seulement de couche d'isolation électrique mais encore de couche-tampon.

En effet, des défauts seraient créés si l'on formait du nitrure de silicium directement sur le drain 26, obtenu par épitaxie et gravure, puis de la silice enterrée, par oxydation thermique.

Avant de déposer le métal servant à former la couche 77, il est possible (mais pas indispensable) de remplir de métal les cavités 78 et 80 (figure 7) qui existent sous les espaceurs 42 et 44 du fait des précédentes étapes du procédé. On utilise à cet effet un dépôt chimique en phase vapeur de cobalt, de tungstène ou de titane par exemple.

On voit sur la figure 8 les couches de métal 82 résultant de ce dépôt. Ce métal remplit les cavités 78 et 80 tout en recouvrant les flancs des espaceurs 42 et 44 ainsi que la surface des couches 70 et 72.

Au lieu de former ces couches 82, il est possible de recouvrir d'une couche 84 du métal considéré les flancs du trou 74 ainsi que la couche 76 formée dans ce dernier ou encore de former à la fois les couches 82 et 84.

On forme ensuite les contacts du transistor.

Pour ce faire, l'ensemble de la structure de la figure 8 est recouvert par une couche électriquement isolante 86 (figure 9) en verre de silice dopé au phosphore ou au bore. On forme ensuite trois ouvertures qui traversent de part en part cette couche 86 et débouchent respectivement sur les deux zones 77a et 77b de la couche de métal 77 qui correspondent à la grille du transistor et sur la zone 77c de cette couche 77, correspondant au contact de drain du transistor.

On remplit ces trois ouvertures d'un métal, par dépôt chimique en phase vapeur, pour former deux contacts de grille 88 et 90 et un contact supérieur de drain 92.

On forme ensuite, à la surface de la couche 86, trois couches métalliques d'interconnexion 94, 96 et 98 qui prolongent respectivement les contacts 88, 90 et 92.

Le contact de source du transistor n'est pas représenté. Pour l'obtenir, il est possible de conformément au procédé objet de former une couche métallique sur la face inférieure du substrat 18.

On achève ainsi la formation du transistor MOS vertical à grille métallique enterrée conformément au procédé objet de l'invention.

Dans l'exemple donné, on a utilisé du silicium de type p pour le substrat mais l'invention englobe bien entendu les procédés de fabrication qui utilisent un substrat en silicium de type n. Dans ce cas, on forme une source en silicium de type p⁺, un canal en silicium de type n ou en SiGeₓC_{y} de type n et un drain en silicium de type p. On peut bien entendu utiliser tout autre semiconducteur approprié (de type n ou p) pour la formation du transistor.

Lors de la mise en oeuvre de l'invention, on précise qu'on peut avoir intérêt à utiliser un premier métal de grille pour l'obtention d'un transistor à canal n et un deuxième métal de grille, différent du premier métal, pour l'obtention d'un transistor à canal p, de façon à obtenir des tensions de seuil opposées.

Revenons à la figure 9 pour mettre en évidence des possibilités offertes par l'invention. Observons le transistor dans le plan de coupe transversale de la figure 9 et considérons un axe δ de ce plan, cet axe étant sensiblement parallèle à la surface du substrat 18 et orienté vers la droite de la figure 9. Étant donné que la grille est protégée par les espaceurs 42 et 44, l'écart Δ entre la projection de l'extrémité droite E de la grille sur cet axe et l'extrémité droite O du drain (origine de l'axe δ), écart qui est positif dans l'exemple de la figure 9, pourrait être nul, voire négatif, en formant les évidements 46 et 48 (figure 3) de telle façon qu'ils s'enfoncent suffisamment sous l'ensemble isolant 28.

La figure 10 est une vue de dessus schématique et partielle d'un schéma d'implantation d'un exemple de transistor MOS vertical à grille métallique fabriqué selon l'invention.

Sur la figure 10, on voit la source 100, le drain 102 et la grille 104 du transistor. Les références 106, 108 et 110 représentent respectivement le contact de drain, un contact de grille et un contact de source. La référence 112 représente le pré-contact de drain et la référence 114 représente un pilier de silicium qui correspond à l'ensemble de ce qui est référencé 28 y compris (42 et 44) sur la figure 9.

Le substrat sur lequel est formé ce transistor n'est pas représenté.

Par rapport à l'encombrement d'un transistor MOS horizontal classique on gagne au moins un facteur 2 sur la surface occupée. En effet, pour une taille de drain donnée, la largeur du transistor est quatre fois plus importante que dans le cas d'un transistor classique car la grille 104 « entoure » le pilier de silicium 114 sur les quatre côtés. La garde du bord de grille à drain (c'est-à-dire l'espace qui sépare le bord de la grille 104 (voir figure 10) de celui de l'ensemble 28 (voir figure 9) est au maximum égale à la tolérance d'alignement donnée par la lithographie de niveau à niveau c'est-à-dire la lithographie qui permet d'aligner le niveau de grille par rapport au niveau de drain.

La figure 11A est une vue schématique et partielle d'une coupe d'un transistor fabriqué selon l'invention. Elle illustre le cas où le « dépositionnement » de la grille par rapport au drain est nul.

En effet l'invention permet d'admettre une garde entre la grille et le drain nulle car il restera toujours un résidu de métal sous l'espaceur, permettant de réaliser une grille enrobant le drain.

Cela permet de réaliser un transistor de taille plus petite que ceux de l'art antérieur : on gagne une différence de cote sur l'encombrement de la grille sensiblement égale à l'épaisseur de grille.

La figure 11B est une vue de dessus schématique et partielle du transistor de la figure 11A. Cette figure 11A correspond à la coupe AA de la figure 11B.

Sur ces figures 11A et 11B la référence 115 désigne les résidus de métal de planarisation et de contact plus le métal de grille.

Sur la figure 11A, le métal de planarisation et de contact correspond à la référence 77b. Les couches 82 correspondent au métal de grille. On voit aussi la couche isolante 86.

Sur la figure 11B on voit également la source 100, le drain 102, la grille 104, le contact supérieur de drain 106, le contact de grille 108, le contact de source 110, le contact de drain 112 et le pilier de silicium 114.

On peut, grâce à la présente invention, mettre en oeuvre une technologie CMOS à grilles duales métalliques, cette technologie utilisant un métal de potentiel d'extraction du type n⁺ pour les transistors MOS à canal n et un métal de potentiel d'extraction du type p⁺ pour les transistors MOS à canal p.

Pour ce faire, on procède, après l'étape d'épitaxie au fond du trou 74 (figure 7), à un dépôt d'une couche de nitrure de silicium qui protège le HiK des gravures avec masque du matériau de grille ou (et) de grille planarisée du côté où il est sacrificiel. Après polissage des couches métalliques du transistor, on procède à leur élimination par voie humide du côté non désiré, sélectivement par rapport au nitrure de silicium. Après avoir formé la couche isolante 86, on aboutit au transistor MOS vertical du type X fabriqué selon l'invention, qui est schématiquement représenté sur la figure 12.

Pour aboutir au transistor MOS vertical du type X fabriqué selon l'invention que l'on voit sur la figure 13, on protège le métal de grille 77a, 77b et 77c, du côté où ce métal est désiré, par une couche de nitrure de silicium 116.

La couche de nitrure de silicium référencée 116 sert donc de couche d'arrêt au polissage du deuxième métal c'est-à-dire le métal référencé 77a, 77b et 77c.

## Revendications

1. Procédé de fabrication d'un transistor de type MOS vertical, dans lequel :
- on forme une structure comprenant un substrat semiconducteur (18), une zone (27) de source, une zone (23) de canal au dessus de la zone de source, et un drain (26) au-dessus de la zone de canal,
- on forme, par-dessus le drain, un ensemble électriquement isolant (28) comprenant des zones électriquement isolantes (42, 44) de part et d'autre du drain,
- on forme, dans la structure, deux évidements (46, 48) de part et d'autre de l'ensemble électriquement isolant, les flancs respectifs (46a, 48a) de ces évidements les plus proches de l'ensemble électriquement isolant étant situés sous ce dernier, de part et d'autre de la zone de canal, pour former ainsi des cavités (78, 80),
- on forme des couches minces, électriquement isolantes (70, 72) au moins sur ces flancs des évidements et d'autres couches épaisses, électriquement isolantes (66, 67) au fond de ces évidements, et
- on forme la grille (77a, 77b) du transistor de part et d'autre de l'ensemble électriquement isolant et jusque dans les cavités,
dans lequel, pour former l'ensemble électriquement isolant,
- on forme, sur la structure, une première couche (30) qui est électriquement isolante et, sur cette première couche, une deuxième couche (32) qui est également électriquement isolante,
- on grave ces première et deuxième couches de façon à obtenir un élément isolant (34, 36) qui recouvre le drain,
- on forme, par-dessus cet élément isolant, une troisième couche (38) qui est également électriquement isolante, et
- on grave cette troisième couche de façon à former les zones électriquement isolantes (42, 44) et à achever la formation de l'ensemble électriquement isolant,
dans lequel on forme, à travers l'ensemble électriquement isolant, un trou (74) qui s'étend jusqu'au drain, et l'on forme, dans ce trou, une couche (77c) de contact de drain,
et dans lequel on forme en même temps la grille (77a, 77b) et cette couche (77c) de contact de drain.

2. Procédé selon la revendication 1, dans lequel la deuxième couche (32) est en outre apte à servir de couche d'arrêt de planarisation à une couche de métal (77) que l'on forme ultérieurement et qui est destinée à la formation de la grille (77a, 77b) du transistor.

3. Procédé selon la revendication 2, dans lequel la deuxième couche (32) est en nitrure de silicium ou en carbure de silicium.

4. Procédé selon la revendication 3, dans lequel la première couche (30) est en outre apte à servir de couche-tampon.

5. Procédé selon l'une quelconque des revendications 1 à 4, dans lequel on forme la zone (27) de source par implantation, dans le substrat, d'ions aptes à conduire à un dopage de ce substrat ou par épitaxie, sur ce substrat, d'un semiconducteur ayant ce dopage .

6. Procédé selon l'une quelconque des revendications 1 à 5, dans lequel on forme le drain (26) par épitaxie ou par implantation d'ions.

## Claims

1. Fabrication process for a transistor of vertical MOS type, in which:
- a structure is formed comprising a semiconductor substrate (18), a source zone (27), a channel zone (23) above the source zone, and a drain above the channel zone,
- above the drain an electrically insulating assembly (28) is formed comprising electrically insulating zones (42, 44) either side of the drain,
- in the structure two recesses (46, 48) are formed either side of the electrically insulating assembly, the respective sidewalls (46a, 48a) of these recesses the closest to the electrically insulating assembly being positioned beneath the latter, either side of the channel zone, to thus form cavities (78, 80),
- thin electrically insulating layers (70, 72) are formed at least on these sidewalls of the recesses, and other thick electrically insulating layers (66, 67) are formed at the bottom of these recesses, and
- the gate (77a, 77b) of the transistor is formed either side of the electrically insulating assembly and reaching into the cavities,
in which, to form the electrically insulating assembly :
- on the structure a first layer (30) is formed which is electrically insulating and, on this first layer, a second layer (32) is formed which is also electrically insulating,
- these first and second layers are etched to obtain an insulating element (34, 36) which covers the drain,
- above this insulating element, a third layer (38) is formed which is also electrically insulating, and
- this third layer is etched so as to form the electrically insulating zones (42, 44) and to complete the formation of the electrically insulating assembly, in which through the electrically insulating assembly, a hole (74) is formed which extends as far as the drain, and in this hole a drain contact layer (77c) is formed, and in which the gate (77a, 77b) is formed at the same time as this drain contact layer (77c).

2. Process according to claim 1, in which the second layer (32) is also able to act as planarization stop layer for a metal layer (77) which is subsequently formed and which is intended to form the gate (77a, 77b) of the transistor.

3. Process according to claim 2, wherein the second layer (32) is in silicon nitride or silicon carbide.

4. Process according to claim 3, wherein the first layer (30) is also able to act as a buffer layer.

5. Process according to any of claims 1 to 4, wherein the source zone (27) is formed by implanting ions in the substrate that are able to lead to doping of this substrate, or by epitaxy on this substrate of a semiconductor having this doping.

6. Process according to any of claims 1 to 5, wherein the drain (26) is formed by epitaxy or by ion implantation.

## Patentansprüche

1. Verfahren zur Herstellung eines vertikalen MOS-Transistors, in welchem:
- eine Struktur gebildet wird, die ein Halbleiter-Substrat (18), eine Source-Zone (27), eine Kanalzone (23) oberhalb der Source-Zone und einen Drain (26) oberhalb der Kanalzone aufweist,
- oberhalb des Drain eine elektrisch isolierende Anordnung (28) gebildet wird, die elektrisch isolierende Zonen (42,44) beiderseits des Drain aufweist,
- in der Struktur zwei Aussparungen (46,48) beiderseits der elektrisch isolierenden Anordnung gebildet werden, wobei die jeweiligen Flanken (46a,48a) dieser Aussparungen, die am nächsten zu der elektrisch isolierenden Anordnung gelegen sind, unterhalb letzterer beiderseits der Kanalzone angeordnet sind, um auf diese Weise Hohlräume (78, 80) zu bilden,
- dünne elektrisch isolierende Schichten (70,72) mindestens an diesen Flanken der Aussparungen und andere dicke elektrisch isolierende Schichten (66,67) am Boden dieser Aussparungen gebildet werden, und
- das Gate (77a, 77b) des Transistors beiderseits der elektrisch isolierenden Anordnung und bis in die Hohlräume gebildet wird,
in welchem zum Bilden der elektrisch isolierenden Anordnung
- auf der Struktur eine erste Schicht (30), die elektrisch isolierend ist, und auf dieser ersten Schicht eine zweite Schicht (32), die ebenfalls elektrisch isolierend ist, gebildet werden,
- diese erste und zweite Schicht geätzt werden, um so ein isolierendes Element (34,36) zu erzielen, das den Drain bedeckt,
- oberhalb dieses isolierenden Elements eine dritte Schicht (38) gebildet wird, die ebenfalls elektrisch isolierend ist, und
- diese dritte Schicht geätzt wird, um so die elektrisch isolierenden Zonen (42,44) zu bilden und die Bildung der elektrisch isolierenden Anordnung zu erreichen,
in welchem durch die elektrisch isolierende Anordnung hindurch ein Loch (74), das sich bis zu dem Drain erstreckt, gebildet wird und in diesem Loch eine Drainkontaktschicht (77c) gebildet wird,
und in welchem das Gate (77a, 77b) und diese Drainkontaktschicht (77c) gleichzeitig gebildet werden.

2. Verfahren nach Anspruch 1, in welchem die zweite Schicht (32) ferner geeignet ist, einer Metallschicht (77), die später gebildet wird und die für die Bildung des Gate (77a, 77b) des Transistors bestimmt ist, als Planarisationsstoppschicht zu dienen.

3. Verfahren nach Anspruch 2, in welchem die zweite Schicht (32) aus Sliziumnitrid oder Siliziumcarbid ist.

4. Verfahren nach Anspruch 3, in welchem die erste Schicht (30) ferner geeignet ist, als Pufferschicht zu dienen.

5. Verfahren nach einem der Ansprüche 1 bis 4, in welchem die Source-Zone (27) gebildet wird durch Implantation von Ionen, die für eine Dotierung dieses Substrats geeignet sind, in das Substrat oder durch Epitaxie eines Halbleiters, der diese Dotierung hat, auf dieses Substrat.

6. Verfahren nach einem der Ansprüche 1 bis 5, in welchem der Drain (26) mittels Epitaxie oder Ionenimplantation gebildet wird.
